# EUROPEAN PATENT APPLICATION

(11) **EP 4 517 803 A1**
(43) Date of publication of application: **05.03.2025**
(21) Application number: 24172365.9
(22) Date of filing: 25.04.2024
(51) Int. Cl.: H01L 21/768, H01L 23/00

(54) **SEMICONDUCTOR CHIP AND SEMICONDUCTOR PACKAGE THEREWITH**

(30) Priority: 01.09.2023 KR 20230116381
(71) Applicant: Samsung Electronics Co., Ltd., Suwon-si, Gyeonggi-do 16677 (KR)
(72) Inventor: HAN, Jeong Wan, 16677 Suwon-si, Gyeonggi-do (KR); KIM, Byung Kyu, 16677 Suwon-si, Gyeonggi-do (KR); KIM, Jeonghun, 16677 Suwon-si, Gyeonggi-do (KR); KIM, Tae-Hong, 16677 Suwon-si, Gyeonggi-do (KR); JEON, Pyojin, 16677 Suwon-si, Gyeonggi-do (KR); JEONG, Seok Hwan, 16677 Suwon-si, Gyeonggi-do (KR)
(74) Representative: Kuhnen & Wacker Patent- und Rechtsanwaltsbüro PartG mbB

(57) **Abstract**

A semiconductor chip includes a substrate, a device layer and an interconnection layer sequentially on the substrate, and a bonding pad on the interconnection layer. A bottom surface of the bonding pad may be located at a constant level, and a side surface of the bonding pad may have a roughened shape.

## Description

### CROSS-REFERENCE TO RELATED APPLICATIONS

This U.S. non-provisional patent application claims priority under 35 U.S.C. §119 to Korean Patent Application No. 10-2023-0116381, filed on September 1, 2023, in the Korean Intellectual Property Office, the entire contents of which are hereby incorporated by reference.

### BACKGROUND

The present disclosure relates to semiconductor devices, and in particular, to semiconductor chips and methods of fabricating semiconductor packages including the same.

Due to their small-sized, multifunctional, and/or low-cost characteristics, semiconductor devices are being esteemed as important elements in the electronic industry. The semiconductor devices are classified into a semiconductor memory device for storing data, a semiconductor logic device for processing data, and a hybrid semiconductor device including both of memory and logic elements.

Due to the recent increasing demand for electronic devices with a fast speed and/or low power consumption, the semiconductor memory device requires a fast operating speed and/or a low operating voltage. To satisfy the requirement, it is desirable to increase an integration density of the semiconductor memory device. Thus, many studies are being conducted to realize a highly-integrated semiconductor memory device.

### SUMMARY

Some example embodiments of the inventive concepts provide semiconductor chips with improved reliability and semiconductor packages including the same.

According to some example embodiments of the inventive concepts, a semiconductor chip may include a substrate, a device layer and an interconnection layer sequentially on the substrate, and a bonding pad on the interconnection layer. A bottom surface of the bonding pad may be located at a constant level, and a side surface of the bonding pad may have a roughened shape.

According to some example embodiments of the inventive concepts, a semiconductor chip may include a substrate, a device layer and an interconnection layer sequentially on the substrate, a bonding pad on the interconnection layer, and a first insulating layer, a blocking layer, and a second insulating layer sequentially on the interconnection layer. The blocking layer may be located at a level lower than the bonding pad, and the blocking layer may include Al₂O₃.

According to some example embodiments of the inventive concepts, a semiconductor package may include a semiconductor chip. The semiconductor chip may include a substrate, a device layer and an interconnection layer sequentially on the substrate, and a bonding pad on the interconnection layer. A bottom surface of the bonding pad may be located at a constant level, and a side surface of the bonding pad may have a roughened shape.

### BRIEF DESCRIPTION OF THE DRAWINGS

FIG. 1 is a sectional view illustrating a semiconductor chip according to some example embodiments of the inventive concepts.
FIG. 2 is an enlarged view corresponding to a portion 'P1' of FIG. 1.
FIG. 3 is a sectional view illustrating a semiconductor chip according to some example embodiments of the inventive concepts.
FIG. 4 is an enlarged view corresponding to a portion 'P1' of FIG. 3.
FIG. 5 is a sectional view illustrating a semiconductor chip according to some example embodiments of the inventive concepts.
FIG. 6 is a sectional view illustrating a semiconductor chip according to some example embodiments of the inventive concepts.
FIG. 7 is a sectional view illustrating a semiconductor chip according to some example embodiments of the inventive concepts.
FIGS. 8 and 9 are enlarged views illustrating a portion `P1' of FIG. 7.
FIG. 10 is a sectional view illustrating a semiconductor chip according to some example embodiments of the inventive concepts.
FIG. 11 is a sectional view illustrating a semiconductor chip according to some example embodiments of the inventive concepts.
FIG. 12 is a sectional view illustrating a semiconductor chip according to some example embodiments of the inventive concepts.
FIG. 13 is a sectional view illustrating a semiconductor chip according to some example embodiments of the inventive concepts.
FIGS. 14 to 17 are sectional views illustrating a method of fabricating a semiconductor chip, according to some example embodiments of the inventive concepts.
FIG. 18 is a sectional view illustrating a method of fabricating a semiconductor chip, according to some example embodiments of the inventive concepts.
FIG. 19 is a sectional view illustrating a method of fabricating a semiconductor chip, according to some example embodiments of the inventive concepts.
FIG. 20 is a sectional view illustrating a method of fabricating a semiconductor chip, according to some example embodiments of the inventive concepts.
FIGS. 21 to 23 are sectional views illustrating a method of fabricating a semiconductor chip, according to some example embodiments of the inventive concepts.
FIG. 24 is a sectional view illustrating a method of fabricating a semiconductor chip, according to some example embodiments of the inventive concepts.
FIG. 25 is a sectional view illustrating a method of fabricating a semiconductor chip, according to some example embodiments of the inventive concepts.
FIG. 26 is a sectional view illustrating a semiconductor package including a semiconductor chip according to some example embodiments of the inventive concepts.
FIG. 27 is a sectional view illustrating a semiconductor package including a semiconductor chip according to some example embodiments of the inventive concepts.
FIG. 28 is a sectional view illustrating a plurality of semiconductor chips according to some example embodiments of the inventive concepts.
FIG. 29 is a sectional view illustrating a plurality of semiconductor chips according to some example embodiments of the inventive concepts.
FIG. 30 is a sectional view illustrating a plurality of semiconductor chips according to some example embodiments of the inventive concepts.
FIG. 31 is a sectional view illustrating a semiconductor package including a semiconductor chip according to some example embodiments of the inventive concepts.
FIG. 32 is a sectional view illustrating a semiconductor package including a semiconductor chip according to some example embodiments of the inventive concepts.

### DETAILED DESCRIPTION

Example embodiments of the inventive concepts will now be described more fully with reference to the accompanying drawings, in which example embodiments are shown.

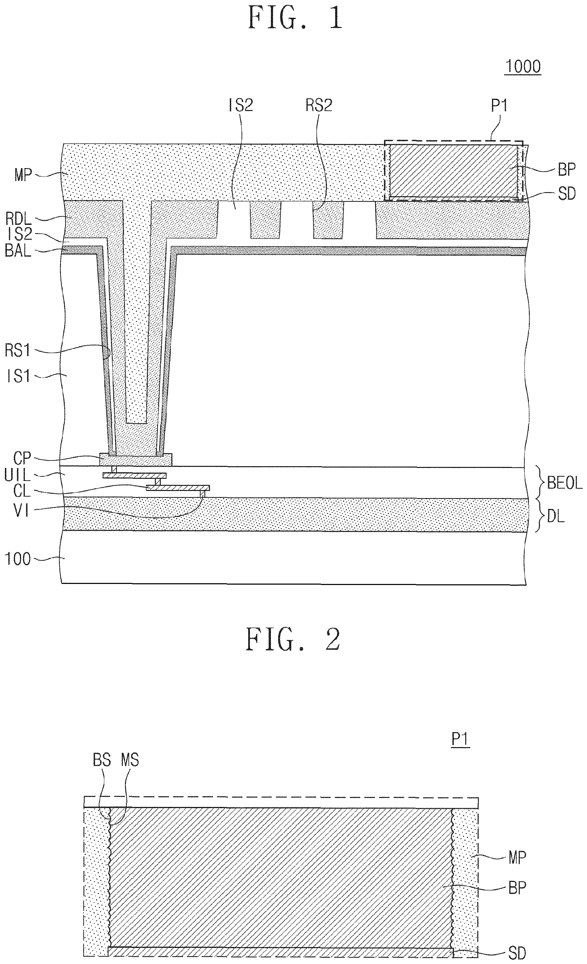

FIG. 1 is a sectional view illustrating a semiconductor chip according to some example embodiments of the inventive concepts. FIG. 2 is an enlarged view corresponding to a portion 'P1' of FIG. 1.

Referring to FIG. 1, a semiconductor chip 1000 may include a substrate 100. In some example embodiments, the substrate 100 may be a single crystalline silicon substrate, a silicon-germanium substrate, or a semiconductor substrate (e.g., a silicon-on-insulator (SOI) substrate) including a semiconductor material.

A device layer DL may be provided on the substrate 100. The device layer DL may include one or more field effect transistors (FETs). As an example, the field effect transistor may be a metal-oxide-semiconductor FET (MOSFET), but the inventive concepts are not limited to this example. In some example embodiments, the device layer DL may include a DRAM cell.

An interconnection layer BEOL may be provided on the device layer DL. The interconnection layer BEOL may include a plurality of conductive lines CL, a plurality of via patterns VI, and an upper insulating layer UIL covering them. The conductive lines CL may be electrically connected to each other through the via patterns VI. The conductive lines CL and the via patterns VImay be electrically connected to the device layer DL. In some example embodiments, each of the conductive line CL and the via pattern VI may be formed of or include at least one of metallic materials (e.g., Ti, Mo, W, Cu, Al, Au, Ta, Ru, and Ir) or metal nitride materials (e.g., nitrides of Ti, Mo, W, Cu, Al, Ta, Ru, and Ir). In the present specification, each of the expressions of "A or B", "at least one of A and B", "at least one of A or B", "A, B, or C", "at least one of A, B, and C", and "at least one of A, B, or C" may be used to represent one of the elements enumerated in the expression or any possible combination of the enumerated elements.

The upper insulating layer UIL may include a composite layer. In some example embodiments, the upper insulating layer UIL may be formed of or include at least one of SiO₂, TEOS, HDP, SiN, SiCN, SiCOH, or SiON.

A conductive pad CP may be provided on the interconnection layer BEOL. The conductive pad CP may be electrically connected to the device layer DL through the conductive lines CL and the via patterns VI. In some example embodiments, the conductive pad CP may be formed of or include at least one of metallic materials (e.g., Ti, Mo, W, Cu, Al, Au, Ta, Ru, and Ir).

A first insulating layer IS1 may be provided on the interconnection layer BEOL. The first insulating layer IS1 may cover the conductive pad CP. The first insulating layer IS1 may be a single layer or a composite layer. In some example embodiments, the first insulating layer IS1 may be formed of or include at least one of SiO₂, TEOS, HDP, or SiN. As an example, a portion of the first insulating layer IS1 may be formed of or include the same material as the upper insulating layer UIL. In this case, it may be hard to distinguish the portion of the first insulating layer IS1 from the upper insulating layer UIL.

A first recess RS1 may be defined in the first insulating layer IS1. The first recess RS1 may be provided on the conductive pad CP. The first recess RS1 may be provided to penetrate the first insulating layer IS1. At least a portion of an inner surface of the first recess RS1 may be defined by the conductive pad CP.

A blocking layer BAL may be provided on the first insulating layer IS1. The blocking layer BAL may be interposed between the first insulating layer IS1 and a second insulating layer IS2 to be described below. The blocking layer BAL may cover a top surface of the first insulating layer IS1. The blocking layer BAL may cover an inner side surface of the first recess RS1. In some example embodiments, the blocking layer BAL may conformally cover the top surface of the first insulating layer IS1 and the inner side surface of the first recess RS1. The blocking layer BAL may be extended to continuously cover the top surface of the first insulating layer IS 1 and the inner side surface of the first recess RS 1. The blocking layer BAL may be in contact with the conductive pad CP. The blocking layer BAL may be located at a level lower than a bonding pad BP, which will be described below. In some example embodiments, the blocking layer BAL may be formed of or include Al₂O₃.

According to some example embodiments of the inventive concepts, the blocking layer BAL, which is formed of or includes Al₂O₃, may cover the top surface of the first insulating layer IS1 and the inner side surface of the first recess RS1. The blocking layer BAL may be configured to prevent or reduce hydroxide (OH) from entering into a layer (e.g., the first insulating layer IS1) thereunder. This may make it possible to prevent or reduce a failure, which is caused in a semiconductor chip by the hydroxide (OH), and thereby to improve the reliability of the semiconductor chip.

The second insulating layer IS2 may be provided on the blocking layer BAL. The second insulating layer IS2 may cover the top surface of the first insulating layer IS1 and the inner side surface of the first recess RS1. In some example embodiments, the second insulating layer IS2 may cover the blocking layer BAL, on the top surface of the first insulating layer IS1 and the inner side surface of the first recess RS1. An upper portion of the second insulating layer IS2 may be provided to enclose a redistribution pattern RDL, which will be described below. In some example embodiments, the second insulating layer IS2 may be formed of or include at least one of SiO₂ or TEOS.

A second recess RS2 may be defined in the second insulating layer IS2. The second recess RS2 may be provided on a top surface of the blocking layer BAL.

The redistribution pattern RDL may be provided on the second insulating layer IS2. The redistribution pattern RDL may be in contact with and electrically connected to the conductive pad CP. The redistribution pattern RDL may be electrically connected to the device layer DL through the conductive pad CP, the conductive lines CL, and the via patterns VI. The redistribution pattern RDL may include a portion that is placed in the first recess RS1 to penetrate the first insulating layer IS1, the blocking layer BAL, and the second insulating layer IS2. The redistribution pattern RDL may further include another portion, which is provided to fill the second recess RS2. A top surface of the redistribution pattern RDL may be located at the same or substantially the same level as a top surface of the second insulating layer IS2. In some example embodiments, the redistribution pattern RDL may be formed of or include at least one of metallic materials (e.g., Ti, Mo, W, Cu, Al, Au, Ta, Ru, and Ir).

A barrier pattern (not shown) may be further interposed between the redistribution pattern RDL and the second insulating layer IS2, and between the redistribution pattern RDL and the conductive pad CP. The barrier pattern may prevent or reduce a material in the redistribution pattern RDL from being diffused into neighboring elements (e.g., the second insulating layer IS2 and the conductive pad CP). In some example embodiments, the barrier pattern may be formed of or include at least one of metal nitride materials (e.g., nitrides of Ti, Mo, W, Cu, Al, Ta, Ru, and Ir).

The bonding pad BP may be provided on the redistribution pattern RDL. The bonding pad BP may be electrically connected to the conductive pad CP through the redistribution pattern RDL. The bonding pad BP may be vertically overlapped with the redistribution pattern RDL. In a region vertically overlapped with the bonding pad BP, the top surface of the redistribution pattern RDL may be located at a constant or substantially constant level. A bottom surface of the bonding pad BP may also be located at a constant or substantially constant level. In the present specification, an expression `a surface is located at a constant or substantially constant or uniform level' will be used to represent that the surface is extended to have a flat or substantially flat shape.

The bonding pad BP may be provided at the uppermost level of the semiconductor chip 1000. The semiconductor chip 1000 may be electrically connected to an external device (e.g., another semiconductor chip or a package substrate) through the bonding pad BP. In some example embodiments, the bonding pad BP may be formed of or include at least one of metallic materials (e.g., Ti, Mo, W, Cu, Al, Au, Ta, Ru, and Ir).

A seed pattern SD may be interposed between the bonding pad BP and the redistribution pattern RDL. In some example embodiments, the seed pattern SD may be formed of or include at least one of metallic materials (e.g., Ti, Mo, W, Cu, Al, Au, Ta, Ru, and Ir). The seed pattern SD may be formed of or include at least one of TiCu or TaCu.

A mold pattern MP may be provided on a side surface BS of the bonding pad BP. The mold pattern MP may cover the redistribution pattern RDL and the second insulating layer IS2. In some example embodiments, the mold pattern MP may include a portion penetrating the first insulating layer IS1. A top surface of the mold pattern MP and a top surface of the bonding pad BP may be located at the same or substantially the same level and may be coplanar or substantially coplanar with each other. In some example embodiments, the mold pattern MP may be formed of or include silicon resin.

Referring to FIG. 2, the side surface BS of the bonding pad BP may be roughened. In the present specification, an expression `a surface of an element is roughened or has a roughened shape' will be used to represent that the surface has an uneven shape. Accordingly, the roughened surface may not be smooth and may be uneven. In some example embodiments, to roughen a surface of an element, an additional process may be performed on the surface of the element. Alternatively, an element may be formed to cover a roughened surface that is formed by an additional process, and in this case, a surface of the element may also have a roughened shape. The additional process may include an etching process that is performed on a surface of the element. In detail, during the etching process, large grains in the element may be etched at a slow rate, compared with small grains. As a result, the large grains may be less or hardly removed by the etching process, while the small grains between the large grains are fully removed. The surface roughening of the element or layer may be achieved by this method, but the inventive concepts are not limited to this method.

The mold pattern MP may be provided to enclose and cover the side surface BS of the bonding pad BP. In some example embodiments, an inner side surface MS of the mold pattern MP may be in contact with the side surface BS of the bonding pad BP. Accordingly, the inner side surface MS of the mold pattern MP may also be roughened, for example, to match the roughed side surface BS of the bonding pad BP.

According to some example embodiments of the inventive concepts, since the side surface BS of the bonding pad BP is roughened, a contact area between the bonding pad BP and the mold pattern MP may be increased. This may make it possible to increase an adhesion strength between the bonding pad BP and the mold pattern MP and to prevent or reduce the delamination issue therebetween and the crack issue therein. Thus, the reliability of the semiconductor chip may be improved.

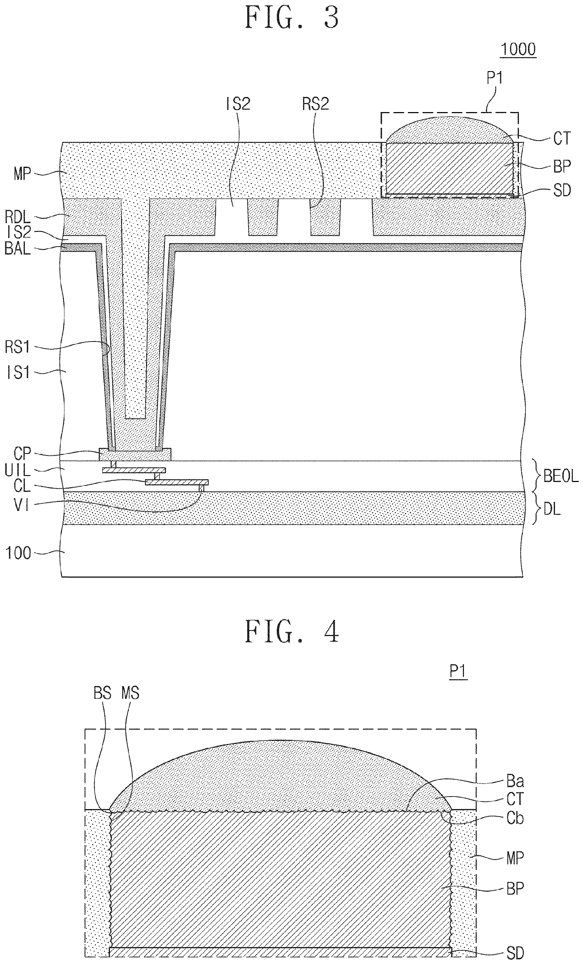

Hereinafter, semiconductor chips according to some example embodiments of the inventive concepts will be described with reference to FIGS. 3 to 13. In the following description, a previously-described element may be identified by the same reference number without repeating an overlapping description thereof, for concise description.

FIG. 3 is a sectional view illustrating a semiconductor chip according to some example embodiments of the inventive concepts. FIG. 4 is an enlarged view corresponding to a portion 'P1' of FIG. 3.

Referring to FIGS. 3 and 4, a connection terminal CT may be provided on the top surface of the bonding pad BP. The connection terminal CT may be a solder bump or a solder cap. The bonding pad BP may be electrically connected to an external device (e.g., an interposer or a package substrate) through the connection terminal CT. In some example embodiments, the connection terminal CT may be formed of or include at least one of metallic materials (e.g., Ti, Mo, W, Cu, Al, Au, Ta, Ru, and Ir). The connection terminal CT may include a single metal layer or a plurality of metal layers. In some example embodiments, one of the metal layers, which is in contact with the bonding pad BP, may be formed of or include an intermetallic compound (IMC).

A top surface Ba of the bonding pad BP may be roughened, and this may make it possible to increase a contact area between the bonding pad BP and the connection terminal CT. As a result, an adhesion strength between the bonding pad BP and the connection terminal CT may be enhanced, and thus, the delamination issue therebetween and the crack issue therein may be prevented or reduced. Accordingly, the reliability of the semiconductor chip may be improved.

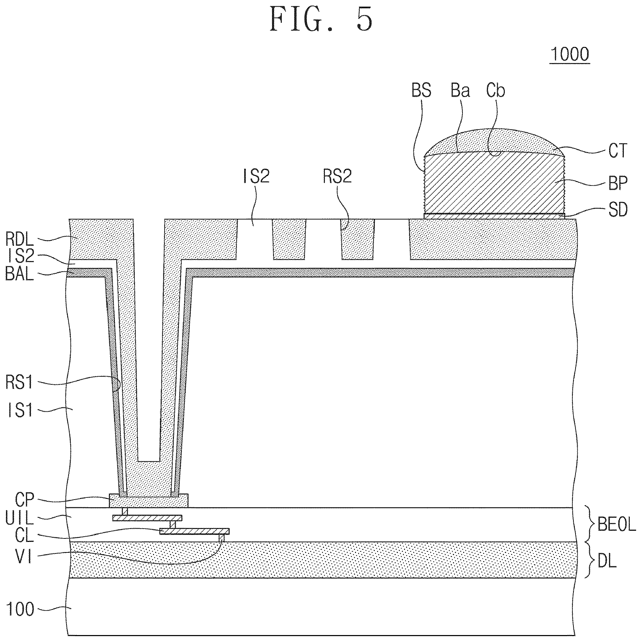

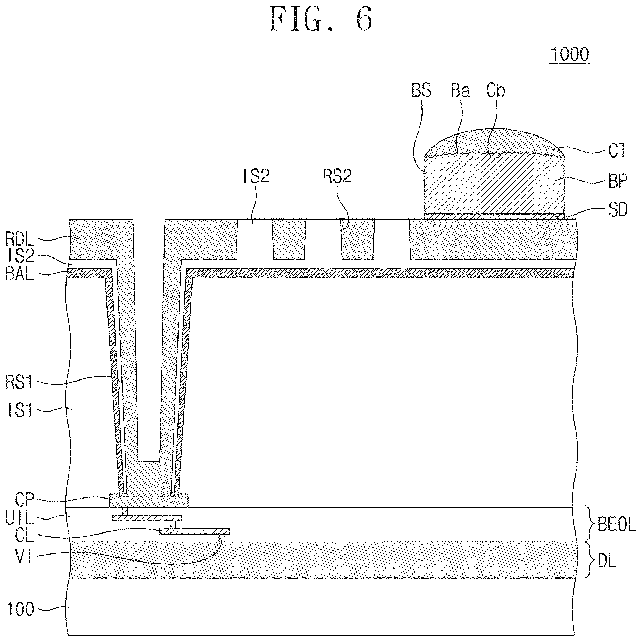

FIGS. 5 and 6 are sectional views illustrating a semiconductor chip according to some example embodiments of the inventive concepts.

Referring to FIGS. 5 and 6, the top surface of the bonding pad BP may have a convex shape upward. This means that a center of the top surface of the bonding pad BP is positioned at a level higher than an edge thereof, regardless of the presence or absence of a roughened portion. The connection terminal CT may be provided on the top surface Ba of the bonding pad BP.

The mold pattern MP described with reference to FIGS. 1 to 4 may be omitted. A mold layer (not shown) may be formed to cover the bonding pad BP and the connection terminal CT, in a subsequent package process.

Referring to FIG. 5, the top surface Ba of the bonding pad BP may not be roughened, compared to the example embodiments of FIGS. 3 and 4. In this case, the connection terminal CT may have a bottom surface Cb that is in contact with the top surface Ba of the bonding pad BP and has a non-roughened shape.

Alternatively, the top surface Ba of the bonding pad BP may be roughened, as shown in FIG. 6. Since the bottom surface Cb of the connection terminal CT is in contact with the top surface Ba of the bonding pad BP, it may have a roughened shape.

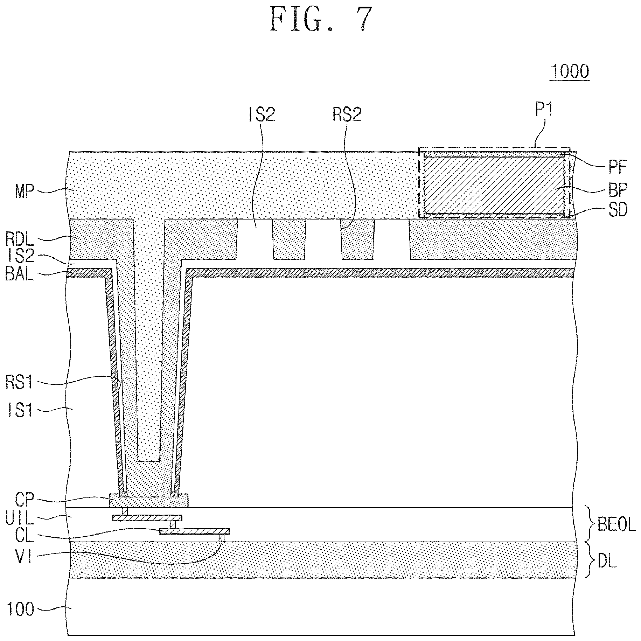

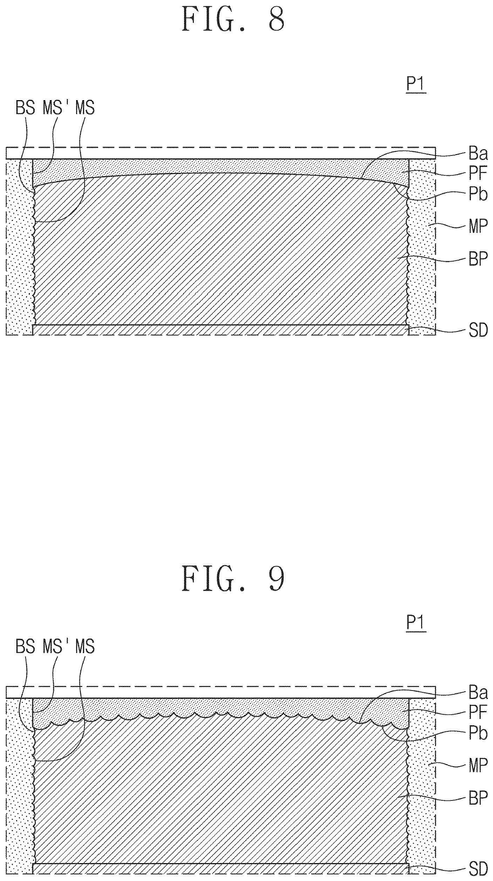

FIG. 7 is a sectional view illustrating a semiconductor chip according to some example embodiments of the inventive concepts. FIGS. 8 and 9 are enlarged views illustrating a portion `P 1' of FIG. 7.

Referring to FIGS. 7 to 9, a screen pad PF may be provided on the top surface Ba of the bonding pad BP. Owing to the screen pad PF, the top surface of the bonding pad BP may not be exposed to the outside. Accordingly, it may be possible to prevent or reduce the bonding pad BP from being oxidized. In some example embodiments, the screen pad PF may include at least one of transition metals. As an example, the screen pad PF may be formed of or include SnAg.

A portion of the mold pattern MP may cover a side surface of the screen pad PF. An inner side surface MS' of the portion of the mold pattern MP may not have a roughened shape. The top surface of the mold pattern MP and a top surface of the screen pad PF may be located at the same or substantially the same level and may be coplanar or substantially coplanar with each other.

Referring to FIG. 8, the top surface Ba of the bonding pad BP may not have a roughened shape. The screen pad PF may have a bottom surface Pb, which is in contact with the top surface Ba of the bonding pad BP and does not have a roughened shape. The top surface Ba of the bonding pad BP may be convex toward an inner portion of the screen pad PF. The bottom surface Pb of the screen pad PF may be concave toward the inner portion of the screen pad PF. However, other profiles may be used, for example, flat, or a reversed concave/convex relationship.

Referring to FIG. 9, the top surface Ba of the bonding pad BP may be roughened, and in this case, it may be possible to increase a contact area between the bonding pad BP and the screen pad PF. Accordingly, an adhesion strength between the bonding pad BP and the screen pad PF may be enhanced, and thus, the delamination issue therebetween and the crack issue therein may be prevented or reduced. As a result, the reliability of the semiconductor chip may be improved.

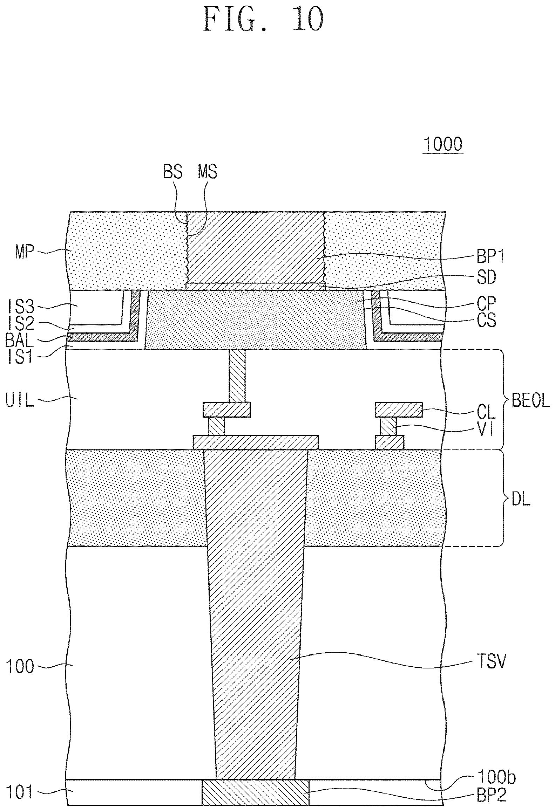

FIG. 10 is a sectional view illustrating a semiconductor chip according to some example embodiments of the inventive concepts.

Referring to FIG. 10, the semiconductor chip 1000 may include the substrate 100. The device layer DL may be provided on the substrate 100. The substrate 100 and the device layer DL may be provided to have the same or substantially the same or similar features as those of FIG. 1.

The interconnection layer BEOL may be provided on the device layer DL. The interconnection layer BEOL may include the conductive lines CL, the via patterns VI, and the upper insulating layer UIL covering them. The conductive lines CL and the via patterns VI may be electrically connected to the device layer DL and may be electrically connected to a penetration plug TSV, which will be described below.

The conductive pad CP may be provided on the interconnection layer BEOL. The conductive pad CP may be electrically connected to the device layer DL and the penetration plug TSV through the conductive lines CL and the via patterns VI.

The first insulating layer IS1, the blocking layer BAL, and the second insulating layer IS2 may be sequentially provided on a side surface CS of the conductive pad CP. The blocking layer BAL may be configured to prevent or reduce hydroxide (OH) from entering into a layer (e.g., the upper insulating layer UIL) thereunder. The blocking layer BAL may be spaced apart from the conductive pad CP by the first insulating layer IS1. The first insulating layer IS 1, the blocking layer BAL, and the second insulating layer IS2 may be located at a level lower than a first bonding pad BP1, which will be described below. In some example embodiments, each of the first and second insulating layers IS1 and IS2 may be formed of or include SiO₂.

A third insulating layer IS3 may be provided on the second insulating layer IS2. The uppermost surface of the third insulating layer IS3 may be located at the same or substantially the same level as a top surface of the conductive pad CP. The third insulating layer IS3 may be a single layer or a composite layer. In some example embodiments, the third insulating layer IS3 may be formed of or include at least one of TEOS or HDP.

The first bonding pad BP1 may be provided on the conductive pad CP. The first bonding pad BP1 may be vertically overlapped with the conductive pad CP. In a region where is vertically overlapped with the first bonding pad BP1, the top surface of the conductive pad CP may be located at a constant or substantially constant level. A bottom surface of the first bonding pad BP may be located at a constant or substantially constant level. The first bonding pad BP1 may be electrically connected to the conductive pad CP, without the redistribution pattern RDL described with reference to FIG. 1. The side surface BS of the first bonding pad BP1 may be provided to have the same or substantially the same or similar features as the side surface BS of the bonding pad BP described with reference to FIG. 2.

The seed pattern SD may be interposed between the first bonding pad BP1 and the conductive pad CP. The seed pattern SD may be provided to have the same or substantially the same or similar features as that of FIG. 1.

The mold pattern MP may be provided on the side surface BS of the first bonding pad BP1. The mold pattern MP may be in contact with both of the conductive pad CP and the blocking layer BAL. The inner side surface MS of the mold pattern MP may have the same or substantially the same or similar features as that of FIG. 2.

A lower insulating layer 101 may be provided on a bottom surface 100b of the substrate 100. The lower insulating layer 101 may include a single layer or a composite layer. In some example embodiments, the lower insulating layer 101 may be formed of or include at least one of SiO₂, SiN, or SiCN.

The penetration plug TSV may be provided to penetrate the substrate 100 and the device layer DL. The penetration plug TSV may be in contact with one of the conductive lines CL of the interconnection layer BEOL. Accordingly, the first bonding pad BP1 may be electrically connected to the penetration plug TSV through the conductive pad CP, the conductive lines CL, and the via patterns VI. The penetration plug TSV may be formed of or include at least one of metallic materials (e.g., Ti, Mo, W, Cu, Al, Au, Ta, Ru, and Ir) or metal nitride materials (e.g., nitrides of Ti, Mo, W, Cu, Al, Ta, Ru, and Ir).

A second bonding pad BP2 may be provided in the lower insulating layer 101. The second bonding pad BP2 may be in contact with the penetration plug TSV. The second bonding pad BP2 may be electrically connected to the first bonding pad BP1 through the penetration plug TSV. In some example embodiments, the second bonding pad BP2 may be formed of or include at least one of metallic materials (e.g., Ti, Mo, W, Cu, Al, Au, Ta, Ru, and Ir).

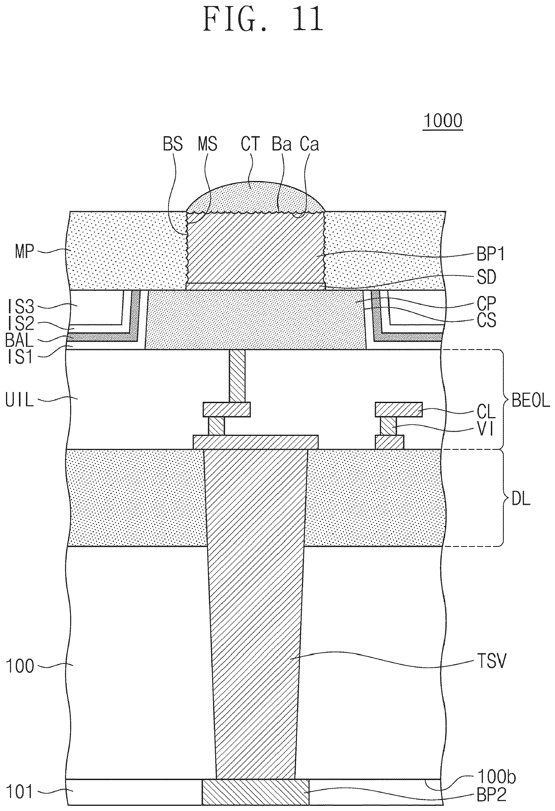

FIGS. 11 to 13 are sectional views illustrating a semiconductor chip according to some example embodiments of the inventive concepts.

Referring to FIGS. 11 to 13, the connection terminal CT may be provided on the top surface Ba of the first bonding pad BP1. The connection terminal CT may be a solder bump or a solder cap. The connection terminal CT may include a single metal layer or a plurality of metal layers. In some example embodiments, one of the metal layers, which is in contact with the first bonding pad BP1, may be formed of or include an intermetallic compound (IMC).

Referring to FIG. 11, the top surface Ba of the first bonding pad BP may have a roughened shape. In this case, the bottom surface Cb of the connection terminal CT, which is in contact with the top surface Ba of the first bonding pad BP, may have a roughened shape. The top surface of the mold pattern MP may be located at a level that is higher (for example, much or substantially higher) than or equal to the top surface Ba of the first bonding pad BP1.

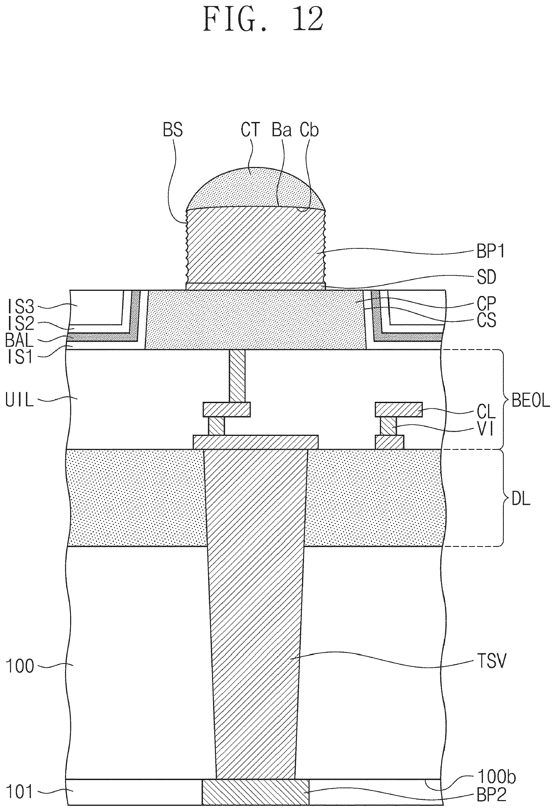

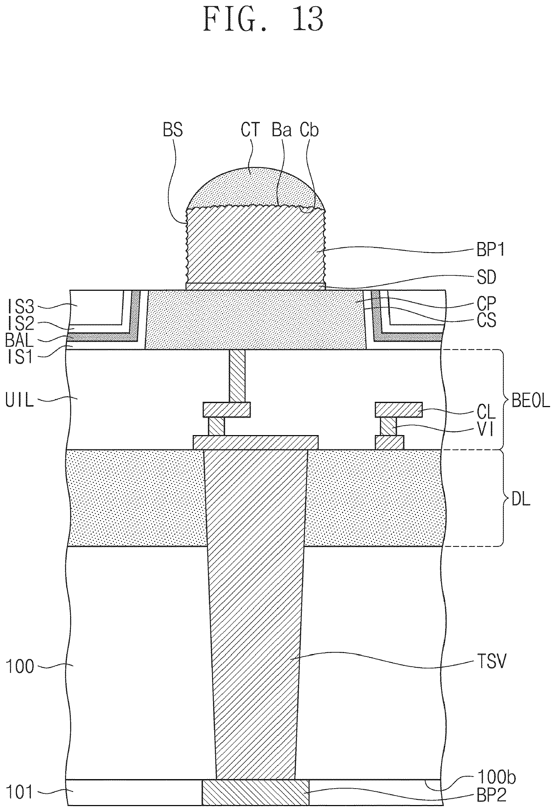

Referring to FIGS. 12 and 13, the top surface Ba of the first bonding pad BP1 may have an upward convex shape. The mold pattern MP described with reference to FIG. 10 may be omitted. In a subsequent package process, a mold layer (not shown) may be formed to cover the first bonding pad BP1 and the connection terminal CT.

Referring to FIG. 12, the top surface Ba of the first bonding pad BP1 may not have a roughened shape. In this case, the bottom surface Cb of the connection terminal CT, which is in contact with the top surface Ba of the first bonding pad BP, may not have a roughened shape.

Referring to FIG. 13, the top surface Ba of the first bonding pad BP1 may have a roughened shape. In this case, the bottom surface Cb of the connection terminal CT, which is in contact with the top surface Ba of the first bonding pad BP, may have a roughened shape.

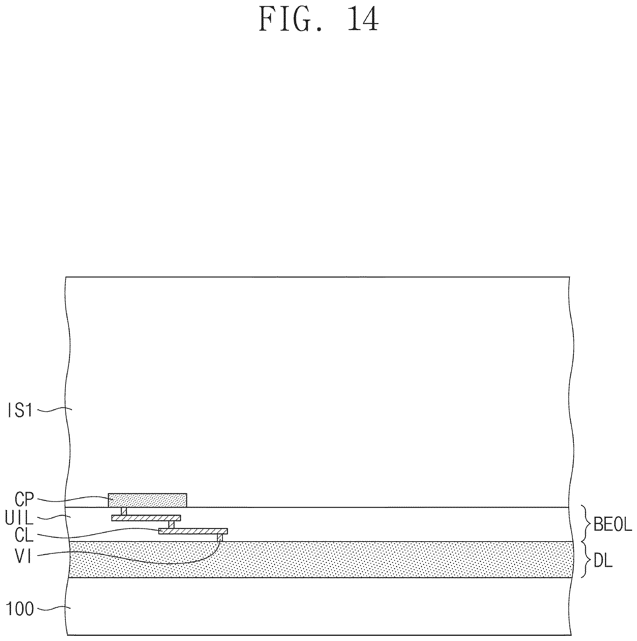

Hereinafter, a method of fabricating a semiconductor chip, according to some example embodiments of the inventive concepts, will be described in more detail with reference to FIGS. 14 to 25. In the following description, a previously-described element may be identified by the same reference number without repeating an overlapping description thereof, for concise description.

FIGS. 14 to 17 are sectional views illustrating a method of fabricating a semiconductor chip according to some example embodiments of the inventive concepts.

The fabrication method, which will be described with reference to FIGS. 14 to 17, may be used to fabricate the semiconductor chip 1000 of FIGS. 1 and 2 and the semiconductor chip 1000 of FIGS. 3 and 4.

Referring to FIG. 14, the substrate 100 may be provided. The device layer DL may be formed on the substrate 100. The formation of the device layer DL may include forming field effect transistors.

The interconnection layer BEOL may be formed on the device layer DL. The formation of the interconnection layer BEOL may include forming the conductive lines CL on the device layer DL, forming the via patterns VI to connect the conductive lines CL to each other, and forming the upper insulating layer UIL to cover them. The upper insulating layer UIL may be formed through one or more layer-forming steps, in consideration of the steps of forming the conductive lines CL and the via patterns VI, but the inventive concepts are not limited to the order or ways of the layer-forming steps. Next, the conductive pad CP may be formed on the interconnection layer BEOL.

The first insulating layer IS1 may be formed on the interconnection layer BEOL. The first insulating layer IS1 may be formed to cover a top surface of the upper insulating layer UIL. The first insulating layer IS1 may be formed to cover the top and side surfaces of the conductive pad CP. The first insulating layer IS1 may be formed through one or more layer-forming steps.

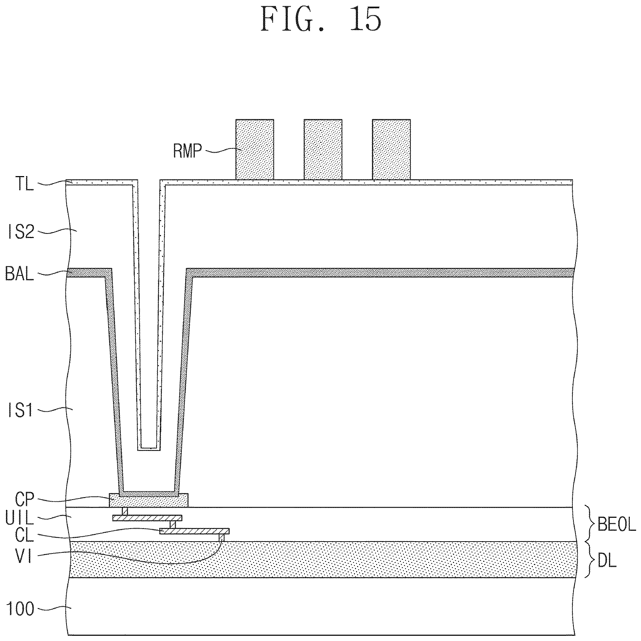

Referring to FIG. 15, a patterning process may be performed to remove a portion of the first insulating layer IS1. Accordingly, the first recess RS1 may be formed in the first insulating layer IS1, and the inner side surface of the first recess RS1 may be exposed to the outside. During the patterning process, an upper portion of the conductive pad CP may be partially recessed to a specific (or, alternatively, desired) depth, and a portion of the top surface of the conductive pad CP may be exposed to the outside.

The blocking layer BAL may be formed to conformally cover the exposed top surface of the first insulating layer IS1, the exposed inner side surface of the first recess RS1, and the exposed top surface of the conductive pad CP (including the recessed portion thereof). The second insulating layer IS2 may be formed to conformally cover the blocking layer BAL. The second insulating layer IS2 may further device a second recess corresponding to the first recess RS1. A temporary layer TL may be formed to conformally cover the second insulating layer IS2. In some example embodiments, the temporary layer TL may be formed of or include at least one of SiN or SiCN.

A redistribution mask pattern RMP may be formed on the temporary layer TL. The redistribution mask pattern RMP may be formed such that it is not vertically overlapped with the conductive pad CP.

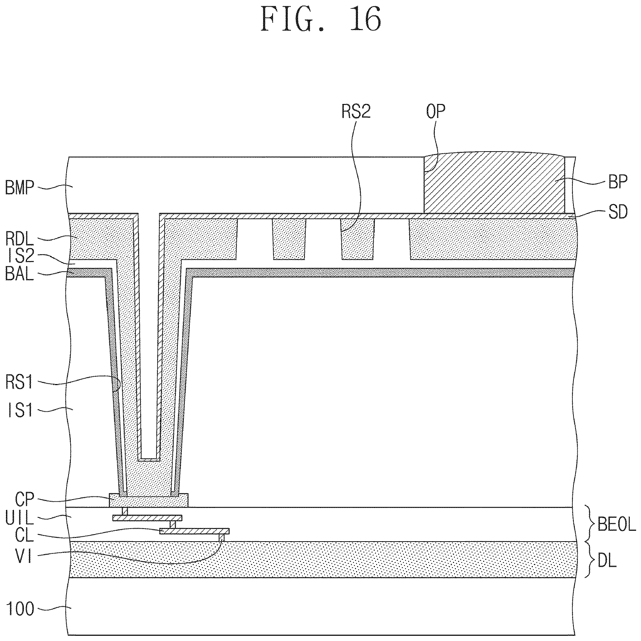

Referring to FIG. 16, a removal process on the second insulating layer IS2 and the temporary layer TL may be performed using the redistribution mask pattern RMP as an etch mask. Accordingly, a portion of the top surface of the conductive pad CP may be exposed to the outside again. In some example embodiments, the removal process may leave a portion of the blocking layer BAL which extends along the recessed portion of the top surface of the conductive pad CP not exposed to the outside. During the removal process, the second recess RS2 may be formed in the second insulating layer IS2. During the removal process, a remaining portion of the temporary layer TL may be left on a top surface of the portion of the second insulating layer IS2.

Thereafter, a barrier pattern (not shown) may be formed to conformally cover the exposed top surface of the conductive pad CP, the second insulating layer IS2, and the temporary layer TL. The redistribution pattern RDL may be formed to cover the barrier pattern. The redistribution pattern RDL may be formed in the first and second recesses RS1 and RS2 and may cover the top surface of the second insulating layer IS2. The redistribution pattern RDL may be formed along the inner side surface of the first recess RS1 and may fill the second recess RS2. Next, the redistribution pattern RDL on the top surface of the second insulating layer IS2 may be removed. The redistribution pattern RDL in the first and second recesses RS1 and RS2 may not be removed by the removal process and may be left after the removal process. In some example embodiments, the removal process may be performed to remove the temporary layer TL from the top surface of the second insulating layer IS2, and thus, the top surface of the second insulating layer IS2 may be exposed to the outside. Thereafter, the seed pattern SD may be formed to conformally cover the redistribution pattern RDL and the exposed top surface of the second insulating layer IS2.

A bonding mask pattern BMP may be formed to cover the substrate 100. In some example embodiments, a portion of the bonding mask pattern BMP may be formed to fill a remaining portion of the first recess RS1.

The bonding pad BP may be formed on the seed pattern SD. In some example embodiments, the formation of the bonding pad BP may include forming an opening OP in the bonding mask pattern BMP and forming the bonding pad BP on the seed pattern SD to fill the opening OP. In some example embodiments, the formation of the bonding pad BP may include performing an electroplating process.

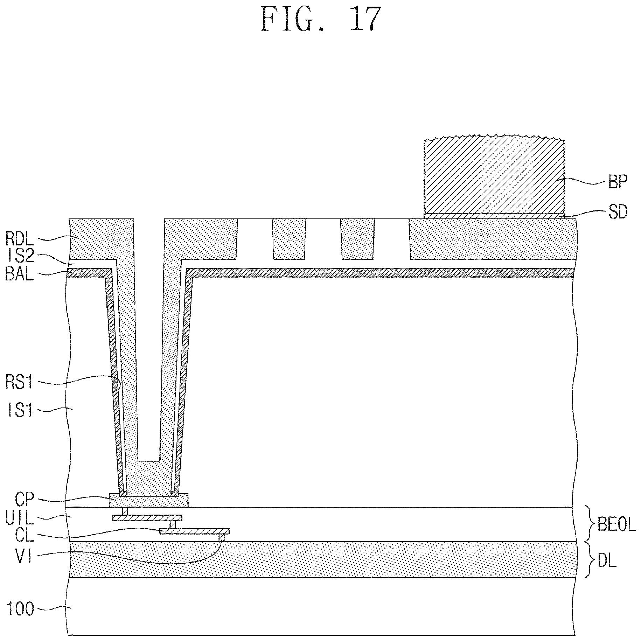

Referring to FIG. 17, the bonding mask pattern BMP and a portion of the seed pattern SD may be removed. In the removal process, a remaining portion of the seed pattern SD may be left between the bonding pad BP and the redistribution pattern RDL. As a result of the removal process, the side surface BS of the bonding pad BP may be exposed to the outside.

Next, the exposed side surface BS and the top surface Ba of the bonding pad BP may be roughened. For example, the roughening process may include performing an etching process. In some example embodiments, the etching process may include a CZ treatment process. In detail, the etching process may be performed to remove small grains of a material and to suppress the etching of large grains. In this case, small grains between the large grains may be removed, and as a result, the surface may have a roughened (e.g., uneven or non-smooth) shape. However, in some example embodiments, the opening OP may have a roughed side surface and therefore, the bonding pad BP may be formed with a roughed surface.

In some example embodiments, after the roughening process on the bonding pad BP, the connection terminal CT of FIG. 6 may be formed to cover the top surface Ba of the bonding pad BP. The connection terminal CT may be formed such that the bottom surface Cb thereof is in contact with the top surface Ba of the bonding pad BP, and thus, the bottom surface Cb may have a roughened shape. In some example embodiments, the formation of the connection terminal CT may include performing a screen printing process. In addition, during the formation of the connection terminal CT, a reflow process may be performed on the connection terminal CT. In this case, the connection terminal CT may be formed to have the profile shown in FIG. 6.

Referring back to FIG. 1, the mold pattern MP may be formed to cover the side surface BS of the bonding pad BP. A portion of the mold pattern MP may be formed to fill a remaining portion of the first recess RS1. During the formation of the mold pattern MP, a removal process may be performed on an upper portion of the mold pattern MP. In some example embodiments, the removal process on the upper portion of the mold pattern MP may include performing a chemical mechanical polishing process. Accordingly, the top surface of the mold pattern MP and the top surface of the bonding pad BP may be located at the same or substantially the same level and may be coplanar or substantially coplanar with each other. The removal process may be performed such that the top surface of the bonding pad BP is located at a same or substantially same level, and in this case, the semiconductor chip 1000 may be formed to have the structure described with reference to FIGS. 1 and 2.

According to some example embodiments of the inventive concepts, the mold pattern MP may be formed after the formation of the bonding pad BP. Thus, it may be possible to omit a removal (e.g., etching) process on the mold pattern MP and to prevent or reduce the mold pattern MP and the redistribution pattern RDL from being damaged by the removal process. As a result, the reliability of the semiconductor chip may be improved.

Compared to the example embodiments of FIG. 1, to fabricate the semiconductor chip 1000 of FIGS. 3 and 4, an additional process may be further performed after the formation of the mold pattern MP of FIG. 1.

Referring to FIG. 3, a roughening process may be performed on the top surface Ba of the bonding pad BP, after the formation of the mold pattern MP described with reference to FIG. 1. Accordingly, the top surface Ba of the bonding pad BP may have a roughened shape. The roughening process may be performed using a method that is similar to the method described with reference to FIG. 17. Thereafter, the connection terminal CT may be formed to cover the bonding pad BP the top surface Ba. The bottom surface Cb of the connection terminal CT may be formed to be in contact with the top surface Ba of the bonding pad BP, and thus, the bottom surface Cb may have a roughened shape.

In some example embodiments, the formation of the connection terminal CT may include performing a screen printing process. In addition, a reflow process may be performed on the connection terminal CT, during the formation of the connection terminal CT. Accordingly, the connection terminal CT may be formed to have the profile shown in FIG. 3, and in this case, the semiconductor chip 1000 may be fabricated to have the structure described with reference to FIGS. 3 and 4.

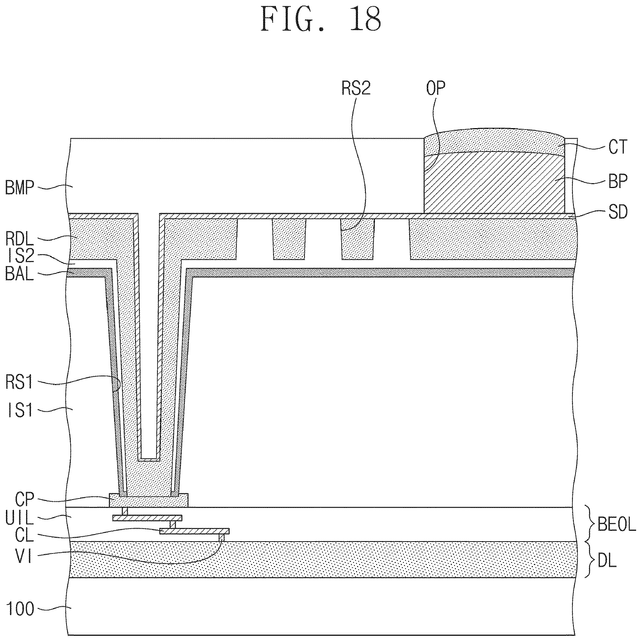

FIG. 18 is a sectional view illustrating a method of fabricating a semiconductor chip, according to some example embodiments of the inventive concepts.

The fabrication method, which will be described with reference to FIG. 18, may be used to fabricate the semiconductor chip 1000 of FIG. 5.

Referring to FIG. 18, after the process of forming the opening OP in the bonding mask pattern BMP described with reference to FIG. 16, the bonding pad BP and the connection terminal CT may be sequentially formed in the opening OP of the bonding mask pattern BMP. The connection terminal CT may be formed to cover the top surface of the bonding pad BP. In some example embodiments, the formation of the connection terminal CT may include performing an electroplating process.

Referring to FIG. 5, the bonding mask pattern BMP and a portion of the seed pattern SD may be removed. The removal process may be performed to expose the side surface BS of the bonding pad BP to the outside, and here, the top surface of the bonding pad BP may not be exposed to the outside, due to the connection terminal CT.

Next, a reflow process may be performed on the connection terminal CT. Accordingly, the connection terminal CT may be formed to have the profile shown in FIG. 5.

The exposed side surface BS of the bonding pad BP may be roughened. The roughening process may be performed in a manner similar to that described with reference to FIG. 17, and in this case, the semiconductor chip 1000 may be fabricated to have the structure described with reference to FIG. 5.

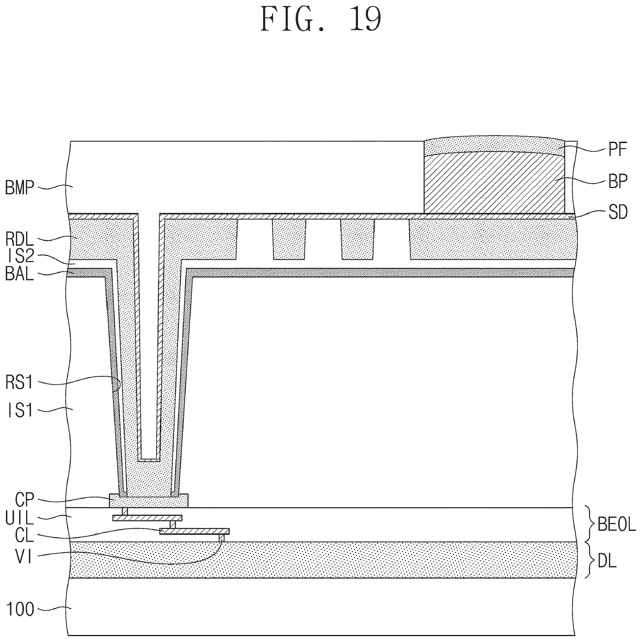

FIG. 19 is a sectional view illustrating a method of fabricating a semiconductor chip, according to some example embodiments of the inventive concepts.

The fabrication method, which will be described with reference to FIG. 19, may be used to fabricate the semiconductor chip 1000 of FIGS. 7 and 8.

Referring to FIG. 19, after the process of forming the opening OP in the bonding mask pattern BMP described with reference to FIG. 16, the bonding pad BP and the screen pad PF may be sequentially formed in the opening OP of the bonding mask pattern BMP. The screen pad PF may be formed to cover the top surface of the bonding pad BP. Accordingly, it may be possible to prevent or reduce the bonding pad BP from being oxidized. In some example embodiments, the formation of the screen pad PF may include performing an electroplating process.

Referring to FIG. 7, the bonding mask pattern BMP and a portion of the seed pattern SD may be removed. The removal process may be performed to expose the side surface BS of the bonding pad BP to the outside, and here, the top surface of the bonding pad BP may not be exposed to the outside, due to the screen pad PF.

The exposed side surface BS of the bonding pad BP may be roughened. The roughening process may be performed using a method that is similar to the method described with reference to FIG. 17.

Thereafter, the mold pattern MP may be formed to cover a side surface of the bonding pad BP and a side surface of the screen pad PF. During the formation of the mold pattern MP, a removal process may be performed on an upper portion of the mold pattern MP. Accordingly, the top surface of the mold pattern MP may be formed at the same or substantially the same level as the top surface of the screen pad PF, and in this case, the semiconductor chip 1000 may be fabricated to have the structure described with reference to FIGS. 7 and 8.

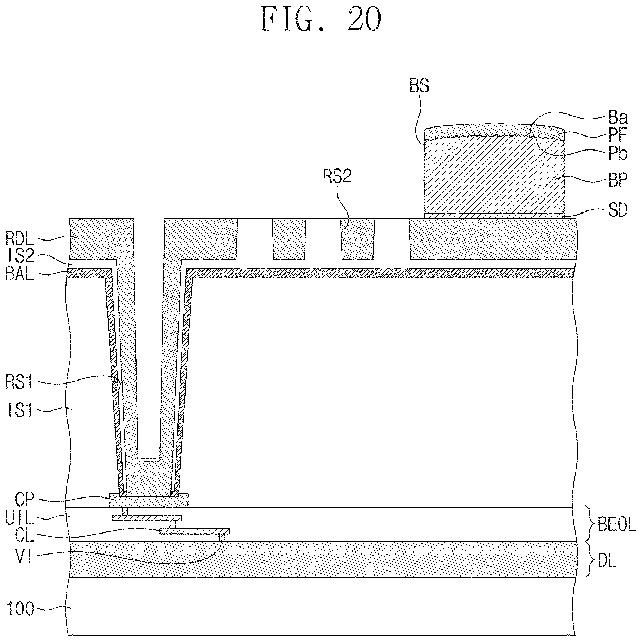

FIG. 20 is a sectional view illustrating a method of fabricating a semiconductor chip, according to some example embodiments of the inventive concepts.

The fabrication method, which will be described with reference to FIG. 20, may be used to fabricate the semiconductor chip 1000 of FIGS. 7 and 9.

Referring to FIG. 20, after the roughening process on the bonding pad BP described with reference to FIG. 17, the screen pad PF may be formed to cover the top surface of the bonding pad BP. In some example embodiments, the formation of the screen pad PF may include performing a screen printing process. The screen pad PF may be formed such that the bottom surface Pb thereof is in contact with the top surface Ba of the bonding pad BP, and thus, the bottom surface Pb of the screen pad PF may have a roughened shape.

Next, the semiconductor chip 1000 described with reference to FIGS. 7 and 9 may be formed using the afore-described fabrication method.

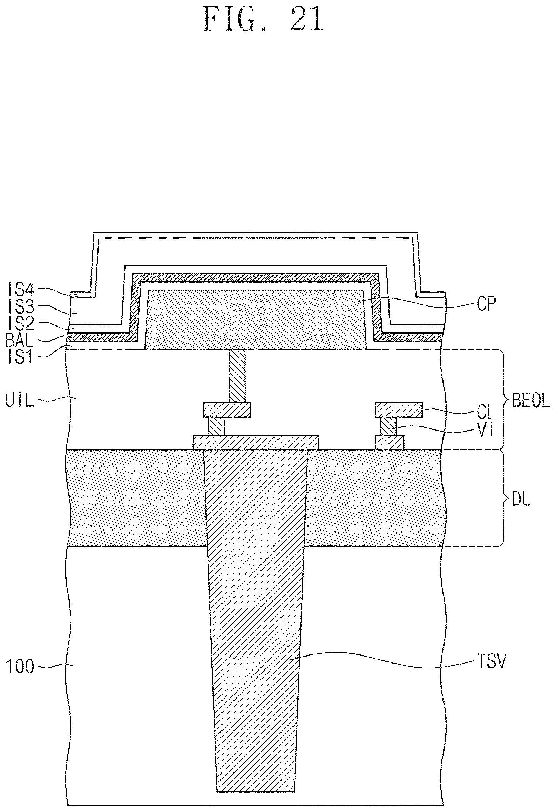

FIGS. 21 to 23 are sectional views illustrating a method of fabricating a semiconductor chip, according to some example embodiments of the inventive concepts.

The fabrication method, which will be described with reference to FIGS. 21 to 23, may be used to fabricate the semiconductor chip 1000 of FIG. 10 and the semiconductor chip 1000 of FIG. 11.

Referring to FIG. 21, the substrate 100 may be provided. The device layer DL may be provided on the substrate 100. The device layer DL may be formed by a method that is similar to that described with reference to FIG. 14.

The penetration plug TSV may be formed in the device layer DL and the substrate 100. The penetration plug TSV may be formed to penetrate the device layer DL and to extend into the substrate 100.

The interconnection layer BEOL may be formed on the device layer DL. The interconnection layer BEOL may be formed by a method that is similar to that described with reference to FIG. 14. One of the conductive lines CL may be formed to cover a top surface of the penetration plug TSV. Thereafter, the conductive pad CP may be formed on the interconnection layer BEOL.

The first insulating layer IS 1, the blocking layer BAL, and the second insulating layer IS2 may be formed to sequentially cover the top surface of the upper insulating layer UIL. The first insulating layer IS 1, the blocking layer BAL, and the second insulating layer IS2 may be formed to cover side and top surfaces of the conductive pad CP. The third insulating layer IS3 and a fourth insulating layer IS4 may be formed to sequentially cover the second insulating layer IS2. In some example embodiments, the fourth insulating layer IS4 may be formed of or include at least one of SiN or SiCN.

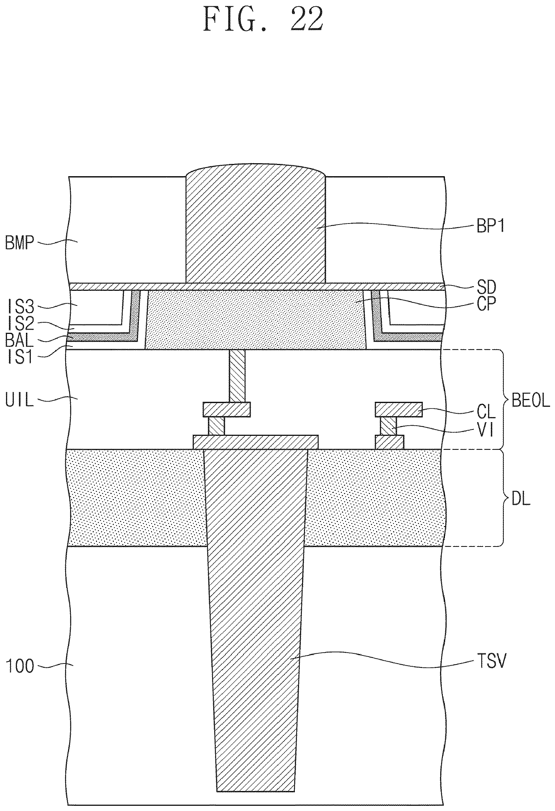

Referring to FIG. 22, the seed pattern SD may be formed to cover the entire top surface of the substrate 100. The seed pattern SD may be formed on the top surface of the conductive pad CP. The bonding mask pattern BMP may be formed on the seed pattern SD.

The first bonding pad BP1 may be formed on the conductive pad CP. In some example embodiments, the first bonding pad BP1 may be formed by a method that is similar to the method of forming the bonding pad BP, described with reference to FIG. 16.

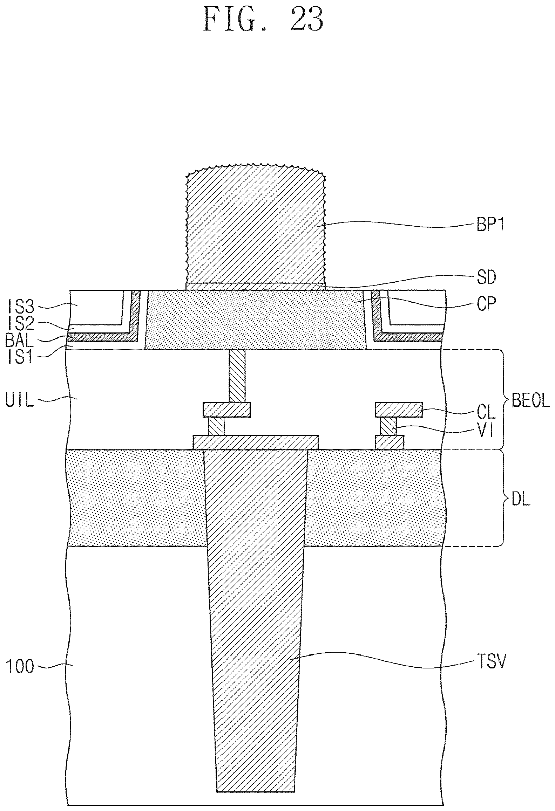

Referring to FIG. 23, the bonding mask pattern BMP and the seed pattern SD may be removed. A portion of the seed pattern SD may be left between the first bonding pad BP1 and the conductive pad CP. As a result of the removal process, the side surface BS of the first bonding pad BP1 may be exposed to the outside.

Next, the exposed side surface BS and the top surface Ba of the first bonding pad BP1 may be roughened. The roughening process on the first bonding pad BP1 may be performed using a method that is similar to the roughening process on the bonding pad BP described with reference to FIG. 17.

Referring to FIG. 10, the mold pattern MP may be formed to cover the side surface BS of the first bonding pad BP1. During the process of forming the mold pattern MP, a removal process may be performed on an upper portion of the mold pattern MP. Accordingly, the top surface of the mold pattern MP and a top surface of the first bonding pad BP1 may be located at the same level or substantially the same level and may be planar or substantially coplanar with each other. During the removal process, the top surface of the first bonding pad BP1 may be formed to be located at a constant or substantially constant level.

Thereafter, a removal process may be performed on a lower portion of the substrate 100. Accordingly, the bottom surface 100b of the substrate 100 may be positioned at the same or substantially the same level as a bottom surface of the penetration plug TSV.

The lower insulating layer 101 may be formed on the bottom surface 100b of the substrate 100. Next, the second bonding pad BP2 may be formed in the lower insulating layer 101. The second bonding pad BP2 may be formed to be in contact with the penetration plug TSV, and in this case, the semiconductor chip 1000 may be fabricated to have the structure described with reference to FIG. 10.

Compared to the example embodiments of FIG. 10, to fabricate the semiconductor chip 1000 of FIG. 11, an additional process described below may be further performed after the formation of the mold pattern MP of FIG. 10 and before the removal process on the lower portion of the substrate 100.

Referring to FIG. 11, after the formation of the mold pattern MP described with reference to FIG. 10, a roughening process may be performed on the top surface Ba of the first bonding pad BP1. Accordingly, the top surface Ba of the first bonding pad BP1 may have a roughened shape. Thereafter, the connection terminal CT may be formed to cover the top surface Ba of the first bonding pad BP1. Accordingly, the bottom surface Cb of the connection terminal CT may be disposed to be in contact with the top surface Ba of the first bonding pad BP1, and thus, the bottom surface Cb may also be roughened.

In some example embodiments, the formation of the connection terminal CT may include performing a screen printing process. In addition, during the formation of the connection terminal CT, a reflow process may be performed on the connection terminal CT. Accordingly, the connection terminal CT may be formed to have the profile shown in FIG. 11.

Next, the semiconductor chip 1000 described with reference to FIG. 11 may be formed using the afore-described fabrication method.

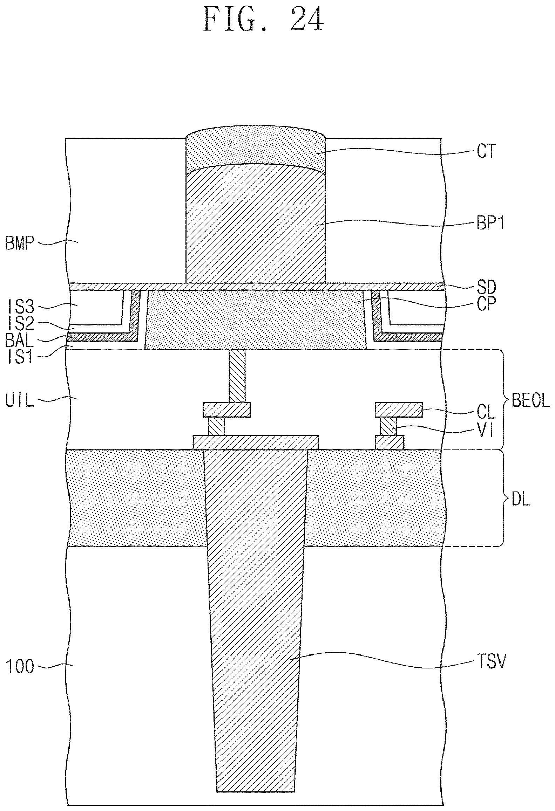

FIG. 24 is a sectional view illustrating a method of fabricating a semiconductor chip, according to some example embodiments of the inventive concepts.

The fabrication method, which will be described with reference to FIG. 24, may be used to fabricate the semiconductor chip 1000 of FIG. 12.

Referring to FIG. 24, after the formation of the bonding mask pattern BMP described with reference to FIG. 22, the first bonding pad BP1 and the connection terminal CT may be sequentially formed in the opening OP of the bonding mask pattern BMP. The connection terminal CT may be formed to cover the top surface of the first bonding pad BP1. In some example embodiments, the formation of the connection terminal CT may include performing an electroplating process.

Referring to FIG. 12, the bonding mask pattern BMP and a portion of the seed pattern SD may be removed. The removal process may be performed to expose the side surface BS of the first bonding pad BP1 to the outside, and here, the top surface of the first bonding pad BP1 may not be exposed to the outside, due to the connection terminal CT.

Thereafter, a reflow process may be performed on the connection terminal CT. Accordingly, the connection terminal CT may be formed to have the profile shown in FIG. 12.

The exposed side surface BS of the first bonding pad BP1 may be roughened. The roughening process may be performed using a method that is similar to the method described with reference to FIG. 17. Compared to the example embodiments of FIG. 10, the process of forming the mold pattern MP may be omitted.

Next, the semiconductor chip 1000 described with reference to FIG. 12 may be formed using the afore-described fabrication method.

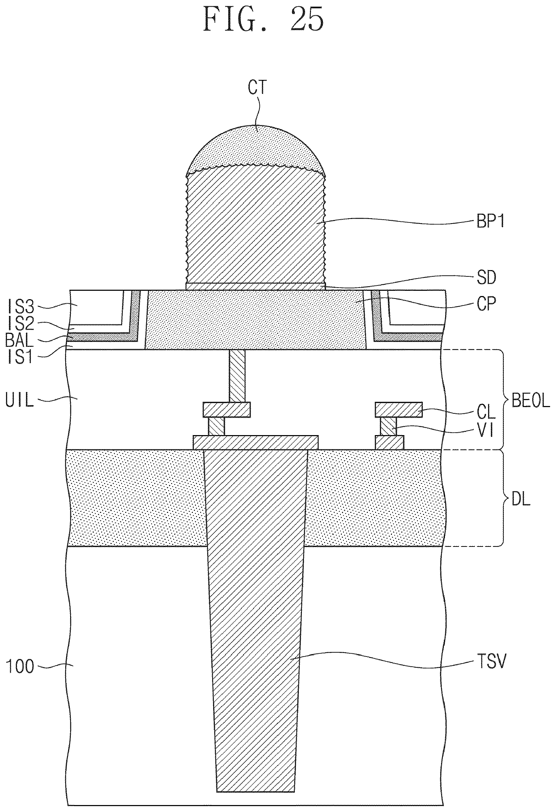

FIG. 25 is a sectional view illustrating a method of fabricating a semiconductor chip, according to some example embodiments of the inventive concepts.

The fabrication method, which will be described with reference to FIG. 25, may be used to fabricate the semiconductor chip 1000 of FIG. 13.

Referring to FIG. 25, the connection terminal CT may be formed to cover the top surface Ba of the first bonding pad BP 1, after the roughening process on the first bonding pad BP1 described with reference to FIG. 23. Since the bottom surface Cb of the connection terminal CT is formed to be in contact with the top surface Ba of the first bonding pad BP1, it may have a roughened shape.

In some example embodiments, the formation of the connection terminal CT may include performing a screen printing process. In addition, during the formation of the connection terminal CT, a reflow process may be performed on the connection terminal CT. Accordingly, the connection terminal CT may be formed to have the profile shown in FIG. 25.

Referring to FIG. 13, the process of forming the mold pattern MP may be omitted, compared to the example embodiments of FIG. 10.

Thereafter, the semiconductor chip 1000 described with reference to FIG. 13 may be formed using the afore-described fabrication method.

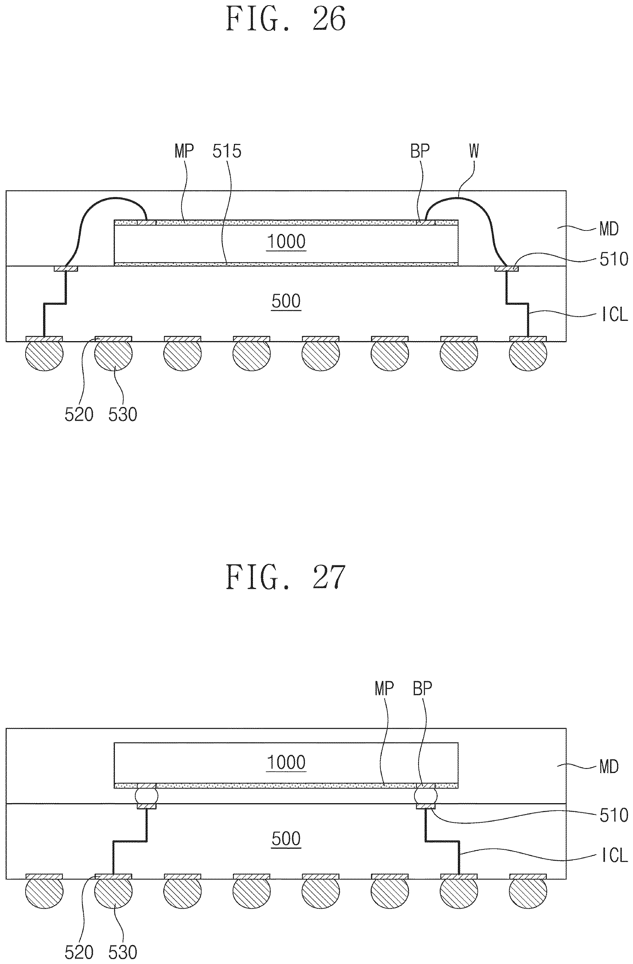

FIG. 26 is a sectional view illustrating a semiconductor package according to some example embodiments of the inventive concepts.

Referring to FIG. 26, a semiconductor package 1 may include the semiconductor chip 1000, a package substrate 500, outer coupling terminals 530, and a mold layer MD.

The semiconductor chip 1000 may be mounted on the package substrate 500. In some example embodiments, the semiconductor chip 1000 may be similar to or be one of the semiconductor chips 1000 described with reference to FIGS. 1, 2, and 7 to 9.

The package substrate 500 may be a printed circuit board (PCB). The package substrate 500 may have a top surface and a bottom surface, which are opposite to each other, and may include inner coupling pads 510, outer coupling pads 520, and internal lines ICL electrically connecting them to each other. The inner coupling pads 510 may be disposed on a top surface of the package substrate 500. The outer coupling pads 520 may be disposed on a bottom surface of the package substrate 500. An adhesive layer 515 may be interposed between the package substrate 500 and the semiconductor chip 1000.

The semiconductor chip 1000 may be electrically connected to the package substrate 500 through an additional element. In some example embodiments, the bonding pad BP of the semiconductor chip 1000 may be electrically connected to the inner coupling pad 510 of the package substrate 500 through a wire W.

The mold layer MD may cover the semiconductor chip 1000, on the package substrate 500. In some example embodiments, the mold layer MD may be formed of or include an epoxy molding compound (EMC).

The outer coupling terminals 530 may be provided below the package substrate 500. Each of the outer coupling terminals 530 may be in contact with a corresponding one of the outer coupling pads 520. Accordingly, the semiconductor package 1 may be electrically connected to an external device (e.g., other semiconductor package, a main board, or the like) through the outer coupling terminals 530.

FIG. 27 is a sectional view illustrating a semiconductor package according to some example embodiments of the inventive concepts.

Referring to FIG. 27, the semiconductor package 1 may include the semiconductor chip 1000, the package substrate 500, the outer coupling terminals 530, and the mold layer MD. In some example embodiments, the semiconductor chip 1000 may be one of the semiconductor chips 1000 described with reference to FIGS. 3 to 6.

Compared to the semiconductor chip 1000 of FIG. 26, the semiconductor chip 1000 may be inverted. Each of the connection terminals CT of the semiconductor chip 1000 may be in contact with a corresponding one of the inner coupling pads 510. Accordingly, the semiconductor chip 1000 may be electrically connected to the package substrate 500 through the connection terminal CT. The adhesive layer 515 described with reference to FIG. 26 may not be provided. The mold layer MD may be provided to enclose and cover side surfaces of the connection terminals CT of the semiconductor chip 1000.

In the case where the semiconductor chip 1000 is the semiconductor chip 1000 described with reference to FIGS. 3 and 4, the mold layer MD may not be in contact with the side surface of the bonding pad BP.

Although not shown in the drawings, if the semiconductor chip 1000 has the structure described with reference to FIG. 5 or FIG. 6, the mold pattern MP may not be provided, and the mold layer MD may be provided to enclose and cover the side surface of the bonding pad BP.

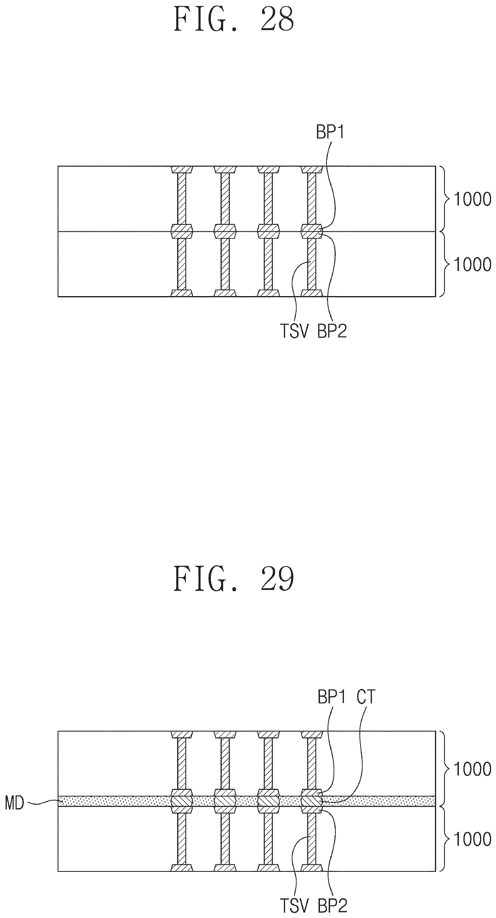

FIG. 28 is a sectional view illustrating a plurality of semiconductor chips according to some example embodiments of the inventive concepts.

Referring to FIG. 28, the semiconductor chips 1000 may be vertically disposed on top of each other. Each of the semiconductor chips 1000 may be the semiconductor chip 1000 described with reference to FIG. 10. FIG. 28 illustrates an example, in which two semiconductor chips 1000 are provided, but the inventive concepts are not limited to this example; for example, three or more semiconductor chips 1000 may be stacked.

The semiconductor chips 1000 may include a first semiconductor chip and a second semiconductor chip stacked on the first semiconductor chip. Each of the first and second semiconductor chips may include the penetration plugs TSV. The first bonding pads BP1 of the first semiconductor chip may be electrically connected to the second bonding pads BP2 of the first semiconductor chip through the penetration plugs TSV. The first bonding pads BP1 of the second semiconductor chip may be electrically connected to the second bonding pads BP2 of the second semiconductor chip through the penetration plugs TSV. In FIG. 29, the first bonding pad BP1 is illustrated to be physically connected to the penetration plug TSV, but the inventive concepts are not limited to this example; for example, they may be electrically connected to each other through an additional contact (not shown) provided therebetween.

Each of the second bonding pads BP2 of the first semiconductor chip may be in contact with a corresponding one of the first bonding pads BP1 of the second semiconductor chip. Accordingly, the penetration plugs TSV of the first semiconductor chip may be electrically connected to the penetration plugs TSV of the second semiconductor chip, without additional connection terminals.

FIG. 29 is a sectional views illustrating a plurality of semiconductor chips according to some example embodiments of the inventive concepts.

Referring to FIG. 29, the semiconductor chips 1000 may be vertically disposed on top of each other. Each of the semiconductor chips 1000 may be the semiconductor chip 1000 described with reference to FIG. 11.

The connection terminals CT may be interposed between the second bonding pads BP2 of the first semiconductor chip and the first bonding pads BP1 of the second semiconductor chip. Accordingly, the second bonding pads BP2 of the first semiconductor chip may be electrically connected to the first bonding pads BP1 of the second semiconductor chip, respectively, through the connection terminals CT.

The mold layer MD may be interposed between the first and second semiconductor chips to cover and enclose the side surfaces of the connection terminals CT. In some example embodiments, the mold layer MD may be formed of or include an epoxy molding compound (EMC).

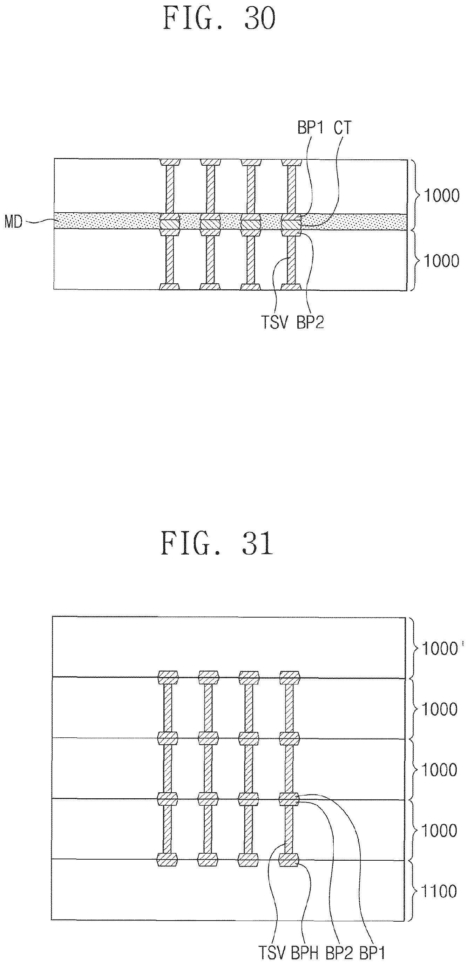

FIG. 30 is a sectional views illustrating a plurality of semiconductor chips according to some example embodiments of the inventive concepts.

Referring to FIG. 30, a plurality of semiconductor chips 1000 may be vertically disposed on top of each other. Each of the semiconductor chips 1000 may be one of the semiconductor chips 1000 described with reference to FIGS. 12 and 13.

The connection terminals CT may be interposed between the second bonding pads BP2 of the first semiconductor chip and the first bonding pads BP1 of the second semiconductor chip.

The mold layer MD may be interposed between the first and second semiconductor chips. The mold layer MD may be provided to enclose and cover the side surfaces of the first bonding pads BP1 and the side surfaces of the connection terminals CT. That is, one of the bonding pads (for example, one of the first bonding pads BP1) may extend into the mold layer MD.

FIG. 31 is a sectional view illustrating a semiconductor package including a semiconductor chip according to some example embodiments of the inventive concepts.

Referring to FIG. 31, a semiconductor package 2000 may include a base chip 1100 and a plurality of semiconductor chips 1000 and 1000' on the base chip 1100. As shown in FIG. 31, the semiconductor chips 1000 may be the semiconductor chips 1000 described with reference to FIG. 28, but the inventive concepts are not limited to this example. Alternatively, although not shown in the drawings, the semiconductor chips 1000 may be one of the semiconductor chips 1000 described with reference to FIGS. 29 and 30.

The base chip 1100 may be electrically connected to the semiconductor chips 1000 and 1000' and may include a host core or a buffer die. The host core may include a processor, which is configured to execute various operations. The buffer die may be configured to receive commands, data, and signals, which are transmitted from the outside, and to send them to the semiconductor chips 1000 and 1000'. In other words, the semiconductor chips 1000 and 1000', which are connected to the base chip 1100, may be used to execute various tasks, depending on signals transmitted from the base chip 1100.

The semiconductor chips 1000 and 1000' may be electrically connected to the base chip 1100 through the penetration plugs TSV. In some example embodiments, the base chip 1100 may include a base bonding pad BPh, which is placed at the uppermost level thereof, and the penetration plugs TSV may be electrically connected to the base chip 1100 through the base bonding pad BPh. In some example embodiments, the penetration plugs TSV may not be provided in the uppermost semiconductor chip 1000', but the inventive concepts are not limited to this example.

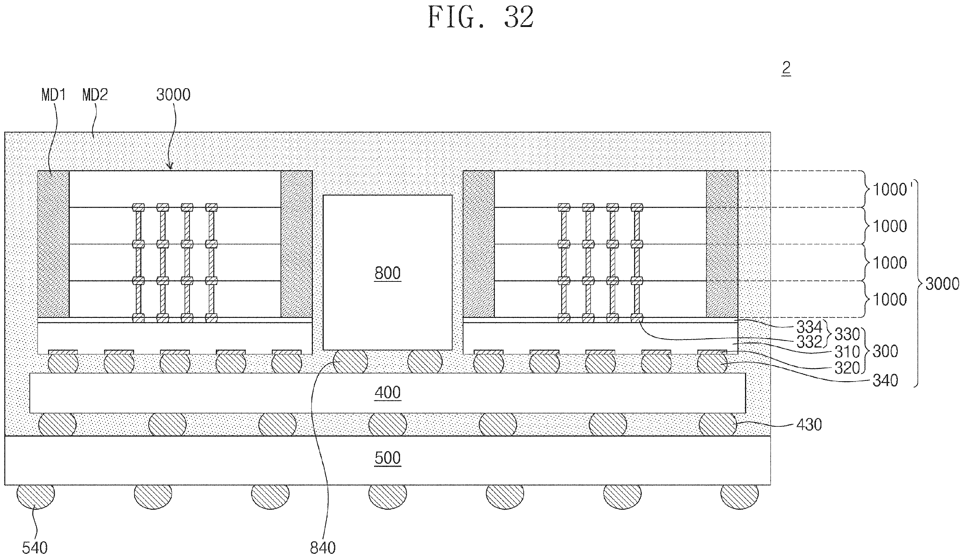

FIG. 32 is a sectional view illustrating a semiconductor package including a semiconductor chip according to some example embodiments of the inventive concepts.

Referring to FIG. 32, a semiconductor package 2 may include package substrates 400 and 500, a memory structure 3000, and a host structure 800. The memory structure 3000 and the host structure 800 may be provided on the package substrates 400 and 500 and may be horizontally spaced apart from each other. The memory structure 3000 and the host structure 800 may be electrically connected to each other through the package substrates 400 and 500.

In some example embodiments, the package substrates 400 and 500 may include a first package substrate 400 and a second package substrate 500. The first package substrate 400 may be placed on the second package substrate 500, and the memory structure 3000 and the host structure 800 may be placed on the first package substrate 400. The first package substrate 400 may be an interposer, and the second package substrate 500 may be a printed circuit board (PCB). First inner connection terminals 430 may be provided to electrically connect the first package substrate 400 to the second package substrate 500. Second inner connection terminals 540 may be provided to electrically connect the semiconductor package 2 to an external device (e.g., a main board).

The memory structure 3000 may include a base chip 300, a plurality of semiconductor chips 1000 and 1000' on the base chip 300, a first mold layer MD1 enclosing the semiconductor chips 1000 and 1000', and a memory connection terminal 340 between the base chip 300 and the package substrates 400 and 500. The semiconductor chips 1000 and 1000' may correspond to the semiconductor chips 1000 and 1000' of FIG. 31. The base chip 300 may correspond to the base chip 1100 of FIG. 31.

The base chip 300 may include a base layer 310, an upper interconnection layer 330, which is provided on one surface (e.g., a top surface) of the base layer 310, and a lower base pad 320, which is placed near an opposite surface (e.g., a bottom surface) of the base layer 310 and is exposed to the outside of the base layer 310. The upper interconnection layer 330 may include an upper base pad 332 and a base protection layer 334 enclosing the upper base pad 332.

The base chip 300 may be configured to allow for redistribution of the semiconductor chips 1000 and 1000'. The upper base pad 332 and the lower base pad 320 may be electrically connected to circuit interconnection lines in the base layer 310 and may constitute a redistribution circuit in conjunction with the circuit interconnection lines. The memory connection terminal 340 may be placed between the lower base pad 320 and the package substrates 400 and 500. The memory connection terminal 340 may include a solder ball or a solder bump.

The first mold layer MD1 may include an insulating material. As an example, the first mold layer MD1 may include an epoxy molding compound (EMC). As an example, the first mold layer MD1 may correspond to the mold layer MD of FIG. 30 or the mold layer MD of FIG. 31.

The host structure 800 may be a data processing device. A host connection terminal 840 may be interposed between the host structure 800 and the package substrates 400 and 500. The host connection terminal 840 may connect the host structure 800 electrically to the package substrates 400 and 500. A second mold layer MD2 may be provided on the package substrates 400 and 500 to encapsulate the memory structure 3000 and the host structure 800.

According to some example embodiments of the inventive concepts, a side surface of a bonding pad may be formed to have a roughened shape, and this may make it possible to increase a contact area between the bonding pad and a mold pattern. As a result, an adhesion strength between the bonding pad and the mold pattern may be enhanced, and thus, the delamination issue therebetween and the crack issue therein may be prevented or reduced. Thus, the reliability of the semiconductor chip may be improved.

According to some example embodiments of the inventive concepts, a top surface of the bonding pad may be formed to have a roughened shape, and this may make it possible to increase a contact area between a screen pad and the bonding pad or a contact area between a connection terminal and the bonding pad. As a result, an adhesion strength between the screen pad and the bonding pad or adhesion strength between the connection terminal and the bonding pad may be enhanced, and thus, the delamination issue therebetween and the crack issue therein may be prevented or reduced. Thus, the reliability of the semiconductor chip may be improved.

According to some example embodiments of the inventive concepts, the mold pattern may be formed after the formation of the bonding pad. Accordingly, it may be possible to omit a removal (e.g., etching) process on the mold pattern and to prevent or reduce the mold pattern and the redistribution pattern from being damaged by the removal process. As a result, the reliability of the semiconductor chip may be improved.

According to some example embodiments of the inventive concepts, a blocking layer, which is formed of or includes Al₂O₃, may be provided on a first insulating layer to prevent or reduce hydroxide (OH) from entering into a layer (e.g., the first insulating layer) under the blocking layer. As a result, it may be possible to prevent or reduce a failure, which is caused in a semiconductor chip by the hydroxide, and to improve the reliability of the semiconductor chip.

When the terms "about" or "substantially" are used in this specification in connection with a numerical value, it is intended that the associated numerical value includes a manufacturing or operational tolerance (e.g., ±10 %) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10 %) around the stated numerical values or shapes.

While example embodiments of the inventive concepts have been particularly shown and described, it will be understood by one of ordinary skill in the art that variations in form and detail may be made therein without departing from the spirit and scope of the attached claims.

## Claims

1. A semiconductor chip, comprising:
a substrate;
a device layer and an interconnection layer sequentially on the substrate; and
a bonding pad on the interconnection layer,
a bottom surface of the bonding pad located at a constant level, and
a side surface of the bonding pad having a roughened shape.

2. The semiconductor chip of claim 1, further comprising a mold pattern on the side surface of the bonding pad,
wherein an inner side surface of the mold pattern has a roughened shape.

3. The semiconductor chip of claim 1, wherein a top surface of the bonding pad has a roughened shape.

4. The semiconductor chip of claim 1, further comprising a connection terminal on a top surface of the bonding pad,
wherein a bottom surface of the connection terminal has a roughened shape.

5. The semiconductor chip of claim 1, further comprising a screen pad on a top surface of the bonding pad.

6. The semiconductor chip of claim 5, wherein a bottom surface of the screen pad has a roughened shape.

7. The semiconductor chip of claim 1, further comprising:
a conductive pad on the interconnection layer; and
a redistribution pattern below the bonding pad,
wherein the bonding pad is electrically connected to the conductive pad through the redistribution pattern.

8. The semiconductor chip of claim 1, further comprising a first insulating layer, a blocking layer, and a second insulating layer, which are sequentially on the interconnection layer,
wherein the blocking layer comprises Al₂O₃.

9. The semiconductor chip of claim 1, wherein
the bonding pad is a first bonding pad,
the semiconductor chip further comprises,
a second bonding pad on a bottom surface of the substrate; and
a penetration plug penetrating the substrate, and
the first bonding pad being electrically connected to the second bonding pad via the penetration plug.

10. The semiconductor chip of claim 1, wherein the device layer is a DRAM.

11. A semiconductor chip, comprising:
a substrate;
a device layer and an interconnection layer sequentially on the substrate;
a bonding pad on the interconnection layer; and
a first insulating layer, a blocking layer, and a second insulating layer sequentially on the interconnection layer,
the blocking layer located at a level lower than the bonding pad, and
the blocking layer comprising Al₂O₃.

12. The semiconductor chip of claim 11, wherein the first and second insulating layers comprise SiO₂.

13. The semiconductor chip of claim 11, further comprising a conductive pad below the bonding pad,
wherein the first insulating layer, the blocking layer, and the second insulating layer are sequentially on a side surface of the conductive pad.

14. The semiconductor chip of claim 11, further comprising a redistribution pattern on the interconnection layer,
wherein the redistribution pattern penetrates the blocking layer.

15. The semiconductor chip of claim 11, further comprising a first recess defined in the first insulating layer,
wherein the blocking layer covers an inner side surface of the first recess.
